# EUROPEAN PATENT SPECIFICATION

(11) **EP 0 735 597 B1**
(45) Date of publication and mention of the grant of the patent: **13.02.2002**
(21) Application number: 96105098.6
(22) Date of filing: 29.03.1996
(51) Int. Cl.: H01L 31/068, H01L 31/0288, H01L 31/18

(54) **Silicon solar cell and fabrication method thereof**
Solarzelle aus Silizium und Herstellungsverfahren
Cellule solaire en silicium et fabrication

(30) Priority: 30.03.1995 JP 7288095; 30.01.1996 JP 1389196
(43) Date of publication of application: 02.10.1996
(73) Proprietor: SHARP KABUSHIKI KAISHA, Osaka-shi, Osaka-fu 545-0013 (JP)
(72) Inventor: Hisamatsu, Tadashi, Tsukuba-shi, Ibaraki (JP)
(74) Representative: Müller, Frithjof E., Dipl.-Ing.

(56) References cited:
- US-A- 3 985 579
- US-A- 4 395 583
- ESSDERC 78. 8TH EUROPEAN SOLID STATE DEVICE RESEARCH CONFERENCE, MONTPELLIER, FRANCE, 11-15 SEPT. 1978, vol. 13, no. 12, ISSN 0035-1687, REVUE DE PHYSIQUE APPLIQUEE, DEC. 1978, FRANCE, pages 629-632, XP000652547 LUQUE A ET AL: "Internal quantum efficiency of back illuminated n/sup +/ pp/sup +/ solar cells"
- PATENT ABSTRACTS OF JAPAN vol. 008, no. 185 (E-262), 24 August 1984 & JP 59 076419 A (KOGYO GIJUTSUIN;OTHERS: 0J), 1 May 1984,
- JOURNAL OF APPLIED PHYSICS, vol. 75, no. 10, PART 01, 15 May 1994, pages 5391-5405, XP000456692 ABERLE A G ET AL: "TWO-DIMENSIONAL NUMERICAL OPTIMIZATION STUDY OF THE REAR CONTACT GEOMETRY OF HIGH-EFFICIENCY SILICON SOLAR CELLS"

## Description

### BACKGROUND OF THE INVENTION

### Field of the Invention

The present invention relates to solar cells, and more particularly to a silicon space solar cell preferably used as a power source of a satellite used in outer space where the irradiation intensity of radioactive rays and ultraviolet rays is great.

### Description of the Background Art

One of the most general space solar cells currently used as the power source of a satellite is a Si solar cell with single crystal (Si) as the base material. In accordance with the greater size, multifunction, and long life time of satellites, the need of high output and improvement in the radiation resistance of a Si space solar cell is increasing. Means for high output and improvement in radiation resistance in Si space solar cells will be described hereinafter.

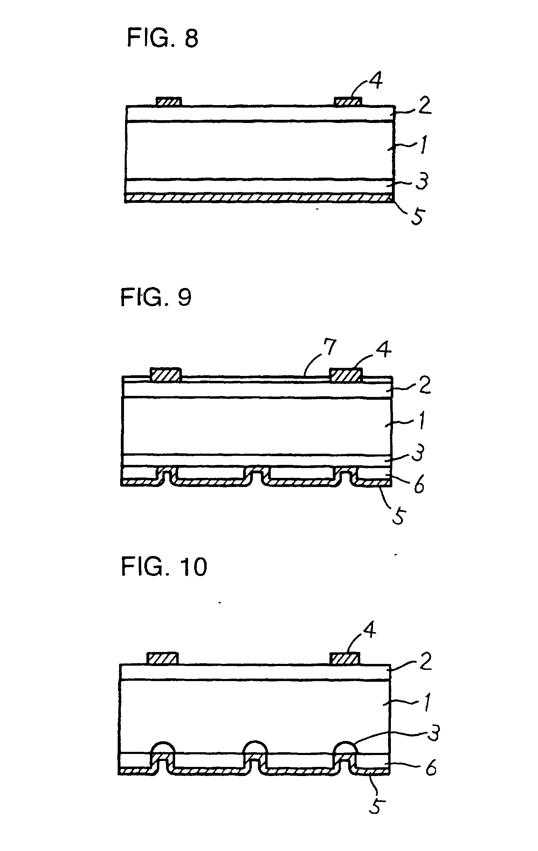

Fig. 8 is a sectional view schematically showing a basic structure of a BSFR (Back Surface Field and Reflector) type solar cell for practical usage. In the solar cell of Fig. 8, an n type diffusion layer 2 is formed by thermal diffusion at a front light receiving surface of a p type Si substrate 1. A p⁺ type layer (BSF layer) 3 is formed similarly by thermal diffusion on the back surface of substrate 1. A front electrode 4 is formed on n type diffusion layer 2, and a back electrode 5 is formed on p⁺ type layer 3. P⁺ type layer 3 in Fig. 8 serves to improve the collection efficiency of carriers to increase the output of the solar cell. Although not shown in Fig. 8, a back surface reflective layer between p⁺ type layer 3 and back electrode 5 for reflecting infrared light, and an anti-reflection coating on the front surface for receiving incident light efficiently are provided. Furthermore, cover glass is adhered in practical usage.

Fig. 9 shows a solar cell developed to further improve the output of the solar cell of Fig. 8. The components of the solar cell of Fig. 9 corresponding to those of the solar cell of Fig. 8 have the same reference characters allotted. More specifically, the basic structure of the solar cell of Fig. 9 is similar to that of Fig. 8 except for the provision of a back surface oxide film 6 and a front surface oxide film 7 at the back surface side and the front surface side, respectively, of substrate 1. Back surface oxide film 6 functions as a passivation film to prevent minority carriers (electrons) generated within p type substrate 1 by light absorption from being recombined with the majority carriers (hole) at the back surface of the cell. Similarly, front surface oxide film 7 functions as a passivation film at the front surface of substrate 1 to prevent minority carriers (hole) generated in n type diffusion layer 2 by light absorption from being recombined with majority carriers (electron) at the front surface of the cell. The solar cell of Fig. 9 allows an output higher than that of the cell of Fig. 8 by preventing recombination of carriers generated by light absorption.

Fig. 10 shows the structure of another solar cell developed to improve the efficiency. The solar cell of Fig. 10 is similar to the solar cell of Fig. 9 provided that p⁺ layer 3 is formed only at the proximity of the region where substrate 1 is brought into contact with back electrode 5 via an opening in back surface oxide film 6.

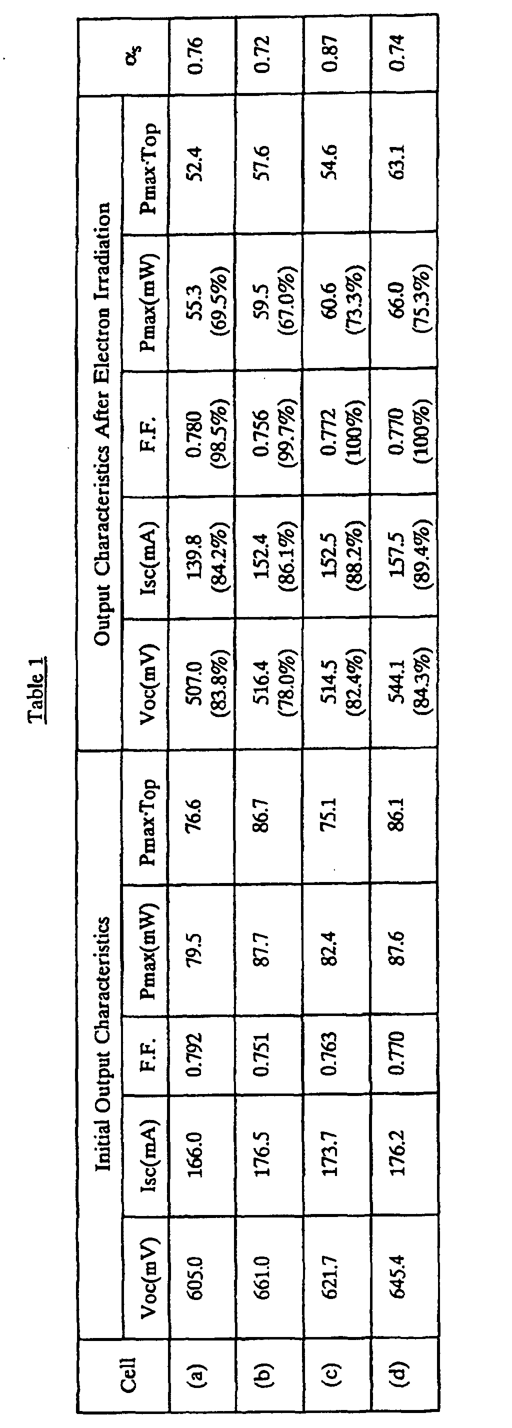

In Table 1, solar cells (a) and (b) exhibit the initial output characteristic and the output characteristics after being subjected to electron irradiation of energy 1 MeV at 1 × 10¹⁵e/cm² corresponding to the solar cells of Figs. 8 and 10, respectively. In contrast to solar cell (a) of Fig. 8, solar cell (b) of Fig. 10 has the maximum power Pₘₐₓ improved by approximately 10 % although open circuit voltage V_{OC} and short-circuit current I_{SC} before and after electron irradiation are high and fill factor FF is slightly low.

The values of the output characteristics of Table 1 are measured using light corresponding to AM0 (solar light of exoatmosphere), and under the temperature of 28°C except for Pₘₐₓ•T_{OP} (mW) representing the maximum power at an operating temperature T_{OP}. The value in % in the parenthesis of the output characteristics after electron irradiation indicates the remaining factor with respect to the output characteristic before electron irradiation. αₛ indicates the solar absorptance.

The radiation resistance of a Si space solar cell will be described hereinafter. In general, a space solar cell is subjected to radiation of electrons, protons, neutrons, α-particles, X-rays, ultraviolet rays, etc. of high energy and high density in the outer space environment, whereby a vacancy in the crystal of the semiconductor substrate of the solar cell, a complex center where a vacancy and an interstitial impurity atom are combined, and a cluster of these defects are formed. These radiation defects electrically act as the recombination center of carriers to reduce the life time and diffusion distance of the minority carriers, whereby the performance of the solar cell is degraded. A Si solar cell for space use is conventionally provided with the following measures (A1) - (A3) to suppress such effects by radiation defect.

(A1) An n-on-p type is selected for the solar cell. Since electrons have a longer life time and diffusion distance than holes, the effect by radiation defect can be relatively reduced by a solar cell of, not the p-on-n type, but of the n-on-p type.

(A2) The thickness of the semiconductor substrate of the solar cell is reduced. A thinner semiconductor substrate results in a fewer absolute number of radiation-induced defects included therein to allow the number of minority carriers captured by these defects reduced.

(A3) The pn junction in the solar cell is provided at a shallow region from the front surface of the semiconductor substrate. In other words, the collection efficiency of the minority carriers generated within the thinned diffusion layer is improved.

However, sufficient radiation resistance cannot be obtained by the solar cells of high output shown in Figs. 9 or 10 even when the above measures of (A1) - (A3) to improve radiation resistance are applied. For example, in Table 1, the output characteristics of a solar cell subjected to electron irradiation of 1 MeV at 1 × 10¹⁵e/cm² is shown which is a criterion for evaluating the radiation resistance. In contrast to the parenthesized remaining factor of 69.5 % of the maximum power Pₘₐₓ after electron irradiation with the initial output characteristic as 100 % in the conventional solar cell (a) corresponding to Fig. 8, the remaining factor of maximum power Pₘₐₓ after electron irradiation is 67.0 % in the solar cell (b) corresponding to Fig. 10. Although not shown in table 1, the solar cell corresponding to Fig. 9 has a similar remaining factor of maximum power Pₘₐₓ after electron irradiation.

Prior art document US-A-4 395 583 describes a solar cell comprising a p-type silicon substrate, an n-type diffusion layer formed at a first main surface side in said p-type substrate, and a p⁺ layer of high doping concentration formed by ion implantation of A1, which is a group III element having an atomic radius greater than that of Si, at a second main surface side in said p-type substrate. A method of fabricating this silicon solar cell comprises the steps of forming an n-type diffusion layer at a first main surface side in a p-type silicon substrate, forming an oxide film so as to cover a second main surface of said p-type substrate, forming a p⁺ layer of high doping concentration at least partially at said second main surface side within said p-type substrate by ion-implanting a group III element having an atomic radius greater than that of an Si atom, and forming an electrode electrically connected to said p⁺ layer.

Further, also document ESSDERC 78, 8th European Solid State Device Research Conference. Montpellier, FR, 11-15 September 1978, in: Revue de Physique Appliquée, December 1978, FR, pages 629-632, XP000652547, vol. 13. No. 12, ISSN 0035-1687; A. Luque et al.: "Internal quantum efficiency of back illuminated n⁺pp⁺ solar cells" discloses a solar cell in which a p⁺ layer is formed by ion implantation of Ga.

Finally, document US-A-3 985 579 describes a method of fabricating a solar cell in which a p⁺ layer is covered by an oxide layer, in which holes are formed and on which an electrode is deposited. A1 and Ga are mentioned as possible p-type ions. According to this document, the p⁺ layer is formed before the oxide layer is deposited.

### SUMMARY OF THE INVENTION

It is an object of the present invention to provide an Si space solar cell of high output sufficiently improved in radiation resistance; it is a further object of the invention to provide a method of fabricating such silicon solar cell.

To solve this object, the present invention provides a silicon solar cell as specified in claim 1 and a method of fabricating a silicon solar cell as specified in claim 5. Preferred embodiments of the invention are described in the subclaims.

A silicon solar cell includes a p-type silicon substrate, an n-type diffusion layer formed at a first main surface side in the substrate, and a p⁺ layer of high doping concentration formed by ion implantation of aluminum (A1) at a second main surface side in the substrate. In this silicon solar cell, Aℓ in the p⁺ layer formed by ion implantation easily combines with oxygen. Therefore, oxygen in the p type silicon substrate is applied to gettering effectively by the p⁺ layer to improve radiation resistance.

According to another aspect a silicon solar cell includes a p type silicon substrate, an n type diffusion layer formed at a first main surface side in the substrate, a p⁺ layer of high doping concentration formed at least partially at a second main surface side in the substrate by ion implantation of the group III element having an atomic radius greater than that of a Si atom, an oxide film on the second main surface of the substrate with an opening, and an electrode electrically connected to the p⁺ layer via the opening of the oxide film. A conventional silicon solar cell including an oxide film is disadvantageous in that recombination of carriers increases due to the interface of Si and the oxide film being damaged by hot carriers generated within the n type diffusion layer by ultraviolet ray irradiation arriving at the interface. In the silicon solar cell of the present aspect, damage towards the interface between the p type substrate region and the p⁺ region formed by ion implantation is suppressed since hot carriers have their energy reduced significantly in passing through the interface due to an abrupt change in the doping concentration and formation of atomic level distortion in the vicinity of the interface. As a result, recombination of carriers is prevented to avoid reduction in the output of a solar cell by ultraviolet ray irradiation.

According to a further aspect, a silicon solar cell has a p⁺ layer formed by ion implantation of Aℓ all over the entire region of the back surface of a p type silicon substrate. Oxygen gettering by Aℓ is effected all over the back surface of the substrate, whereby radiation resistance of a solar cell is improved over the entire region of the back surface of the substrate.

A method of fabricating a silicon solar cell includes the steps of forming an n type diffusion layer at a first main surface side within a p type silicon substrate, forming an oxide film so as to cover a second main surface of the p type substrate, forming a p⁺ layer of high doping concentration at the second main surface side within the p type substrate by ion implantation of the group III element having an atomic radius greater than that of a Si atom via the oxide film, forming an opening in the oxide film, and forming an electrode electrically connected to the p⁺ layer via the opening. According to the method of fabricating a silicon solar cell, ions for forming the p⁺ layer are implanted into the p type substrate through the oxide film after its formation. Therefore, the interface between the p type substrate and the oxide film can be maintained at its relatively favorable situation prior to ion implantation.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view schematically showing a silicon solar cell according to an embodiment of the present invention.

Fig. 2 is a sectional view of a solar cell according to another embodiment of the present invention.

Fig. 3 is a sectional view of a solar cell according to a further embodiment of the present invention.

Figs. 4A-4D are sectional views of the solar cell of Fig. 2 for describing the fabrication method thereof.

Figs. 5A-5D are sectional views of the solar cell of Fig. 2 showing fabrication steps following the step of Fig. 4D.

Fig. 6 shows the energy band structure along the cross section where a back surface oxide film is located in a solar cell of Fig. 9.

Fig. 7 shows the energy band structure along the cross section of the solar cell of Fig. 1.

Fig. 8 is a sectional view of a conventional solar cell.

Fig. 9 is a sectional view of another conventional solar cell.

Fig. 10 is a sectional view of a further conventional solar cell.

### DESCRIPTION OF THE PREFERRED EMBODIMENTS

The most important feature of the present invention is to obtain the following two effects (B1) and (B2) by ion-implantation of the group III element such as Al onto the back surface side of a silicon substrate in a Si space solar cell of high efficiency.

(B1) Allow gettering of oxygen from the Si substrate by the group III element such as At to improve radiation resistance of a silicon solar cell.

(B2) Altering the doping concentration abruptly by ion implantation and form atomic level distortion in the vicinity of the interface between a p⁺ region provided for collecting carriers efficiently and a p type substrate. Since the atomic level distortion acts to reduce significantly the energy of hot carriers, reduction in the output of a silicon solar cell due to ultraviolet ray irradiation can be avoided.

According to the present invention, a Si space solar cell can be provided superior in ultraviolet ray resistance and radiation resistance.

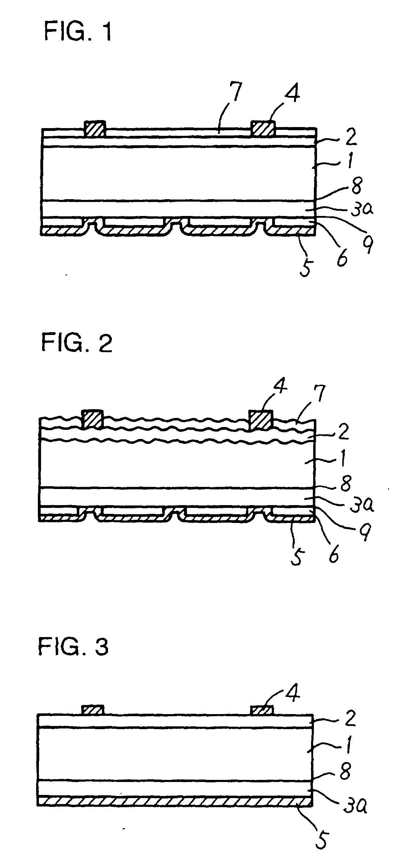

Fig. 1 schematically shows a BSFR type Si space solar cell according to an embodiment of the present invention. In the solar cell of Fig. 1, an n type diffusion layer 2 is formed at a front light receiving surface side of a p type Si substrate 1. A p⁺ type layer (BSF layer) 3a is formed at the back surface of substrate 1. A back surface oxide film 6 is formed on p⁺ type layer 3a. A front surface oxide film 7 is provided on n type diffusion layer 2. A front electrode 4 and a back electrode 5 are formed at the front surface side and the back surface side, respectively, of the substrate. The doping concentration is altered abruptly in the vicinity of an interface 8 between p⁺ type layer 3a and p type Si substrate 1. Distortion in atomic level is formed in the vicinity of interface 8 between p⁺ type layer 3a and p type Si substrate 1 and within p⁺ type layer 3a. As will be described in detail afterwards, an abrupt change in doping concentration and atomic level distortion in the vicinity of interface 8 between p⁺ type layer 3a and p type Si substrate 1 can be implemented by implanting ions having an atomic radius greater than that of Si (for example, Aℓ) into p type Si substrate 1 to form a p⁺ type layer 3a. The atomic radius of Si is 0.117 nm, whereas the atomic radius of Aℓ is 0.141 nm.

The reason why radiation resistance in the solar cell of Fig. 1 is improved significantly will be described hereinafter.

Reduction in the output of a solar cell by irradiation of radioactive rays and the like is considered to be caused by two main factors. One is the direct influence towards the solar cell by electrons which are particles of high energy. The other is the indirect influence towards the solar cell by ultraviolet rays and the like which are photons.

As to the direct effect towards a solar cell, irradiation of a solar cell with electron rays causes the formation of a vacancy in the semiconductor crystal of the cell base material, a complex where a vacancy and an interstitial impurity atom are combined, and a cluster of defects thereof, as previously mentioned in the section of the background art. The output of the solar cell cannot be derived effectively since these lattice defects act as a recombination center.

As to the indirect effect by ultraviolet ray, it is known that hot carriers generated in a silicon substrate apply damage to the binding at the Si/SiO₂ interface when ultraviolet ray having relatively high energy is applied to a solar cell, as described by P.E. Gruenbaum et al. in Applied Physics Letters 52 (17), 25, April 1988. Since the damaged portion at the Si/SiO₂ interface becomes the recombination center, the passivation effect of the SiO₂ film is degraded to lower the output of the solar cell.

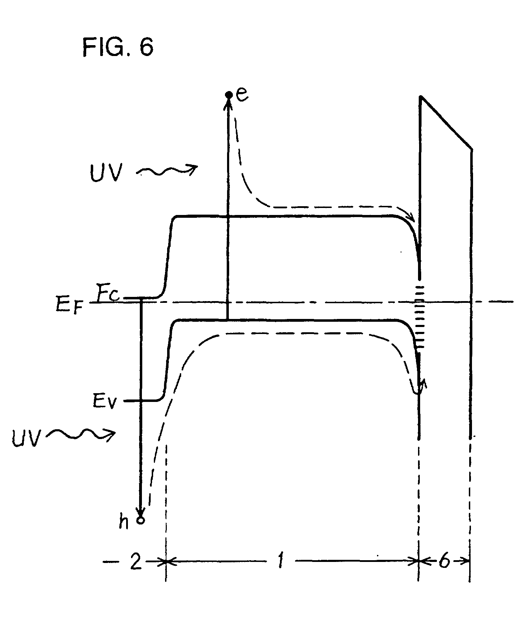

Fig. 6 is an energy band structure for describing the indirect effect by ultraviolet rays. The energy band structure of Fig. 6 shows the band structure and the flow of hot carriers at a cross sectional face where semiconductor substrate 1 is directly in contact with back surface oxide film 6 in the solar cell of Fig. 10. E_{C} indicates the lower limit of the conduction band, E_{V} indicates the upper limit of the valence band, and E_{F} indicates the Fermi level. The "-" sign at the interface between semiconductor substrate 1 and back surface oxide film 6 indicates the interface level. In general, a depletion region is formed at the Si/SiO₂ interface. When a solar cell having the band structure as shown in Fig. 6 is irradiated with ultraviolet rays (UV), hot carriers (electron e and hole h) are generated mainly at the vicinity of the front surface. These hot carriers pass through Si substrate 1 maintaining its high energy to arrive at the Si/SiO₂ interface to apply damage to the binding at the interface. The damage at the interface acts as the recombination center of carriers. This means that the probability of electrons of the minority carriers generated by absorbing solar light recombining with holes of the majority carriers via the recombination center of the Si/SiO₂ interface increases. As a result, it will become difficult to effectively provide the minority carriers generated by photoelectric conversion outside the solar cell as the output. In other words, the effect of back surface passivation is degraded by the hot carriers.

The inventor noted the direct effect by high energy particles to the cell and the indirect effect by photons, and carried out extensive research to implement a solar cell without any output degradation by energy particles of electron rays and that can prevent formation of a recombination center of carriers at a Si/SiO₂ interface by reducing the energy of hot carriers generated by photons of ultraviolet ray before they reach the interface. The inventor finally conceived of a silicon solar cell having the structure of Fig. 1. More specifically, by implanting to the back surface side of substrate 1 ions of the group III element such as Al having an atomic radius greater than that of a Si atom, the above-described problems of the direct and indirect effects towards the cell can be solved to obtain the two advantages set forth in the following.

The first advantage is that the radiation resistance of a solar cell can be improved by the provision of a p⁺ layer 3a formed by ion-implantation of the group III element such as Aℓ. Oxygen from Si substrate 1 is subjected to gettering by p⁺ layer 3a. As a ground thereof, there is a description in, for example, "Semiconductors and Semimetals", volume 11, Solar Cells: Academic Press, pp. 154-157 that the oxygen in a Si substrate is responsible for radiation-induced defect, and a solar cell exhibits superior radiation resistance if the containing amount of oxygen is low. The inventor considered that the radiation resistance of a solar cell can be improved by doping Aℓ at high concentration into Si substrate 1 to take advantage of the fact that Aℓ recombines easily with oxygen to effectively getter the oxygen in Si substrate 1. A solar cell of a structure similar to that shown in Fig. 8 provided that p⁺ layer 3 is formed of an Aℓ-Si alloy layer was actually fabricated and subjected to experiments. As shown in solar cell (c) in Table 1, a remaining factor of 73.3 % was obtained with respect to maximum power Pₘₐₓ after electron irradiation of 1 MeV at 1 × 10¹⁵e/cm² which is the criterion of evaluating the radiation resistance. It is appreciated from this value that the radiation resistance is improved in contrast to the values of 67.70 % - 69.5 % of the retaining rate of the maximum power Pₘₐₓ in conventional solar cells.

In solar cell (a), p⁺ layer 3 was formed by diffusing boron into p type Si substrate 1 in a gas atmosphere including boron in a furnace of a high temperature (approximately 1000°C). In solar cell (c), p⁺ layer 3 of a Si-Aℓ alloy layer was formed by applying paste including Aℓ powder on Si substrate 1 and baking the same in a furnace of approximately 400°C for a short time period. There is a problem that the solar absorptance αₛ in solar cell (c) is increased to result in a higher cell temperature in contrast to those of solar cells (a) and (b). Therefore, maximum power Pₘₐₓ•T_{OP} of solar cell (c) in an operating temperature is 75.1 mW, which is lower than those of cells (a) and (b). According to the embodiment of the present invention, the solar cell of Fig. 1 has Aℓ atoms implanted. Therefore, a thick p⁺ layer 3 of Si-Aℓ alloy such as in cell (c) in Table 1 will not be formed. Therefore, the problem of increase in temperature of the cell does not occur.

Another advantage by ion-implantation is that a structure can be achieved in which the doping concentration changes abruptly from p type substrate 1 to p⁺ layer 3 at the vicinity of the interface 8 between p⁺ layer 3a and p type substrate 1 provided for efficiently collecting carriers and in which distortion of the atomic level is formed. As a result, hot carriers generated within n type diffusion layer 2 due to ultraviolet irradiation lose their energy in passing through the vicinity of interface 8 from p type substrate 1 to p⁺ layer 3a. In other words, interface 9 between p⁺ layer 3a and oxide film 6 will be protected from hot carriers. Thus, the problem of recombination of carriers at the damaged portion in interface 9 is eliminated to avoid reduction in output caused by ultraviolet irradiation.

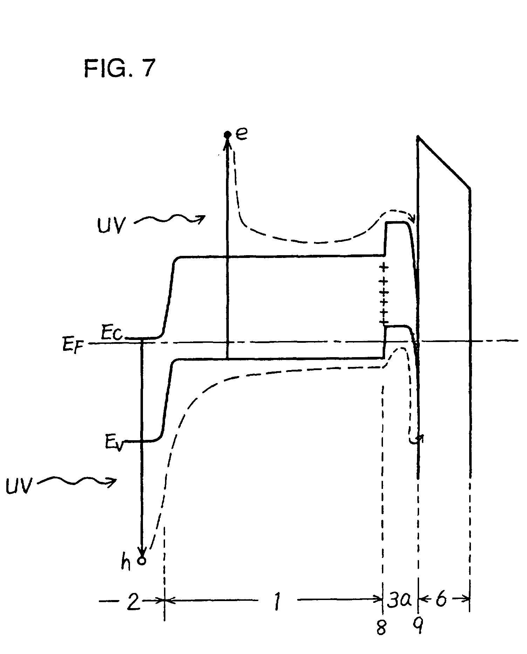

Fig. 7 shows the energy band structure and the flow of hot carriers in the solar cell of Fig. 1 for the purpose of describing the effect of ion-implantation. The energy band structures of Figs. 7 and 6 are similar, provided that the band structure of p⁺ layer 3a formed by ion implantation is included in the energy band structure of Fig. 7. In Fig. 7, interface 8 between n type Si substrate 1 and p⁺ layer 3a is indicated with a "+" sign.

Description was made with reference to Figs. 6 and 7 as though hot carriers (electron **e**, hole **h**) per se generated by ultraviolet rays (UV) apply damage at the interface between Si and an oxide film in order to facilitate the description of the behavior of hot carriers and the effect of the present invention. In practice, a plurality of electrons **e** and holes **h** are present within the Si substrate during operation of a solar cell. It is to be noted that the generated hot carrier per se may not always apply damage, and that another carrier of the same type receiving energy from the hot carrier applies damage.

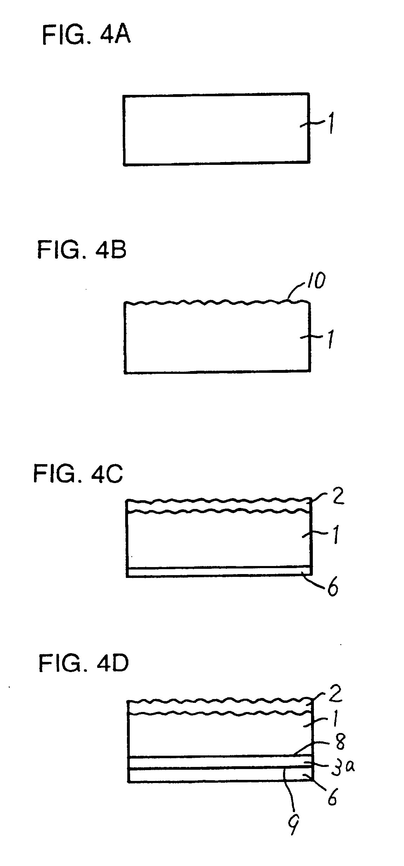

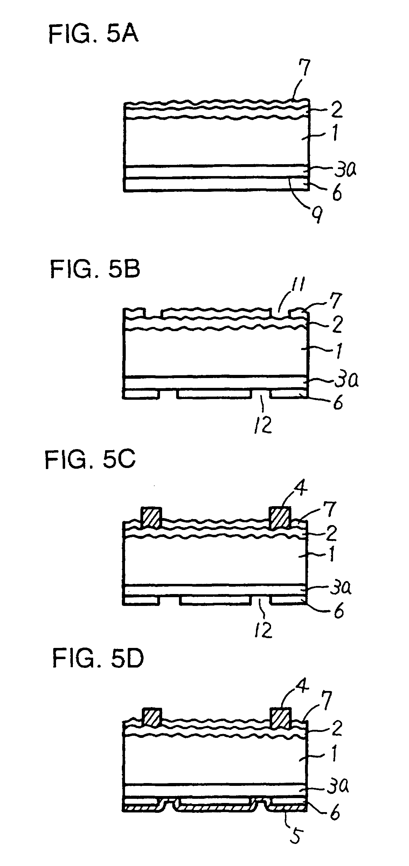

The solar cell of Fig. 1 is only a way of example of the present invention. The present invention can be applied to other various types of solar cells. For example, a texture structure can be introduced into the light receiving surface of the solar cell of Fig. 1, as shown in Fig. 2. A method of fabricating the solar cell of Fig. 2 according to the present invention will be described hereinafter with reference to Figs. 4A-4D and Figs. 5A-5D.

Referring to Fig. 4A, a p type silicon substrate 1 (having a carrier concentration of 1 × 10¹⁵/cm³ - 1 × 10¹⁶/cm³, and a resistance of 1 - 3 Ωcm) is etched to a predetermined thickness (approximately 50 - 200 µm).

Referring to Fig. 4B, an non-reflective surface configuration 10 is formed at the front surface of substrate 1. Configuration 10 can be realized by processing a SiO₂ film deposited by CVD on the surface of substrate 1 by the well-known photolithography and etching the same with an alkali type etchant.

Referring to 4C, an n layer 2 is formed by thermal diffusion of impurities of the group V (phosphorus and the like) from the front surface of substrate 1. In this case, the back surface of substrate 1 is protected by a thick oxide film 6 formed by thermal oxidation in, for example, dry oxygen.

Referring to Fig. 4D, impurities of the group III (Aℓ here) having an atomic radius greater than that of Si are ion-implanted at the back surface side of substrate 1 through oxide film 6. This ion-implantation is the most important feature of the present invention. The thickness of p⁺ layer 3a is set to approximately 1 - several µm, and the carrier concentration thereof is set to at least 1 × 10¹⁸/cm³. By implanting impurities of the group III having an atomic radius greater than that of Si into the back surface of substrate 1, and the doping concentration is altered abruptly and distortion in atomic level is formed in the vicinity of interface 8 between p⁺ layer 3a and p type substrate 1. Even if hot carriers are generated within n type diffusion layer 2 and the like by ultraviolet irradiation, the hot carriers will lose energy in passing through the vicinity of interface 8. Therefore, the bonds at interface 9 between oxide film 6 and p⁺ layer 3a will not be damaged by the hot carriers. Thus, degradation in the output of a solar cell can be avoided.

Since ion implantation of Aℓ atoms into p type substrate 1 is carried out through oxide film 6 after formation thereof, interface 9 between p type substrate 1 and oxide film 6 can be maintained at a relatively favorable situation prior to ion implantation. It is possible to carry out ion implantation prior to formation of oxide film 6. In this case, oxide film 6 will be formed on p⁺ layer 3a having high impurity concentration. In general, formation of oxide film 6 of small interface states and favorable interface characteristics can be expected as the impurity concentration of the substrate is lower. Formation of an ideal oxide film 6 is difficult when the oxide film is to be formed on p⁺ layer 3a having high concentration. Therefore, it is preferable to implant ions of Aℓ after oxide film 6 is formed on p type substrate 1 as shown in Fig. 4D.

The above-described ion implantation does not require a high carrier concentration (for example, 5 × 10¹⁹ - 1 × 10²⁰/cm³) in p⁺ layer 3 as in the case where conventional thermal diffusion is carried out. This is because a back surface passivation effect of a sufficient level can be expected since Si/SiO₂ interface 9 is formed that has less interface states that function as the recombination levels of carriers. Thus, the carrier concentration does not have to be increased to a level as high as in the conventional case. Damage by ion irradiation can occur at the back surface of the cell even by the ion implantation shown in Fig. 4D. Recovery of this damage is carried out at the next step.

Referring to Fig. 5A, recovery of damage caused by ion-implantation is effected by RTA (Rapid Thermal Anneal) at 600°C, for example, for a few minutes. Such a thermal treatment of this level will not effect the pn junction p type substrate 1 and n type substrate 2 or at interface 8 between substrate 1 and p⁺ layer 3a. By introducing dry oxygen of a predetermined concentration into the furnace simultaneous to this RTA method, front surface oxide film 7 can be formed at the same step. The thickness of front surface oxide film 7 is set to 10-20 nm, for example.

Referring to Fig. 5B, openings 11 and 12 are formed at predetermined positions in front surface oxide film 7 and back surface oxide film 6 by the well-known photolithograph method. The etching process can be carried out by any of wet etching and dry etching.

Referring to Fig. 5C, a front electrode 4 is formed by the well known photolithography method.

Referring to Fig. 5D, back electrode 5 is formed so as to cover back surface oxide film 6 and opening 12.

Then, thermal treatment is applied after forming an anti-reflective coating at the front surface side of substrate 1 (not shown). The cell is cut out to a predetermined dimension to be completed as a bare cell. A solar cell with cover glass is obtained by adhering cover glass on the light receiving surface of the bare cell via resin.

Although ion of Al atoms are implanted in the above described embodiment, other ions of the group III element such as Ga (having an atomic radius of 0.125 nm greater than the atomic radius of 0.117 nm of Si) can be used.

Fig. 3 shows a solar cell according to a further embodiment of the present invention. The appearance of the solar cell of Fig. 3 is similar to the conventional solar cell of Fig. 8. The solar cell of Fig. 3 does not include oxide films 6 and 7 as in the solar cell of Fig. 1. The aforementioned problem (B2) of damage at the Si/SiO₂ interface by hot carriers does not occur in the solar cell of Fig. 3. However, the problem of (B1) of output degradation by radioactive ray irradiation is present. Therefore, the radiation resistance can be improved in the solar cell of Fig. 3 by implanting ions such as Aℓ having a great recombination ability with oxygen in forming p⁺ layer 3a. Although Aℓ is used as the atoms to be driven by ion-implantation in the embodiment of Fig. 3, an element of group III that has an atomic radius greater than that of Si atoms and has a relatively high combination with oxygen such as Ga can be used.

(d) in Table 1 represents the characteristics of the solar cell of Fig. 1 which is a recent protocol by the inventor. It is appreciated from Table 1 that initial maximum power Pₘₐₓ of solar cell (d) is equal to that of a conventional cell (b) of high efficiency, and the remaining factor after electron irradiation is superior than that of solar cell (c) using Aℓ paste. Furthermore, since solar cell (d) does not have a thick Si-Aℓ alloy layer 3 formed as in solar cell (c), the solar absorptance α_{S} can be lowered than that of cell (c), and maximum output Pₘₐₓ•T_{OP} under the operating temperature after electron irradiation can be improved. As to the effect of ultraviolet irradiation, no degradation in the output characteristics was observed at an elapse of 700 sun•hours (1 sun represents the intensity of normal solar light) in solar cell (d). Thus, the superior advantage of the present invention was confirmed.

According to one aspect of the present invention, p⁺ layer at the back surface side of a p type silicon substrate is formed by ion-implantation. Since Aℓ easily combines with oxygen, the oxygen within the p type substrate is effectively gettered by the p⁺ layer, whereby the radiation resistance of the silicon solar cell is improved.

According to another aspect of the present invention, the doping concentration is altered abruptly, and distortion in atomic level is formed in the vicinity of the interface between a p⁺ layer formed by implanting ions of group III element having an atomic radius greater than that of Si atom and a p type substrate. Therefore, hot carriers generated within the n type diffusion layer by ultraviolet ray irradiation loses its energy in passing through this interface between the p⁺ layer and the p type substrate, so that the interface between the p⁺ layer and the oxide film is protected from hot carriers. As a result, recombination of carriers generated by the damage portion caused by hot carriers at the interface between a p⁺ region and an oxide film encountered in prior art is prevented, and output degradation caused by ultraviolet irradiation is avoided in a silicon solar cell.

According to a further aspect of the present invention, a p⁺ layer is formed all over the back surface of a p type silicon substrate. Gettering of oxygen by Aℓ is carried out all over the entire region of the back surface of the substrate. Therefore, radiation resistance of a silicon solar cell is improved sufficiently. Since the entire region of the back surface of the substrate is protected from hot carriers, output degradation by ultraviolet irradiation in a solar cell can be sufficiently avoided.

According to yet another aspect of the present invention, an oxide film is formed at the back surface of a p⁺ type silicon substrate and then a p⁺ layer is formed by implanting ions through the oxide film. Therefore, the interface between the substrate and the oxide film can be maintained at a relatively favorable situation prior to ion implantation.

Although the present invention has been described and illustrated in detail, it is clearly understood that the same is by way of illustration and example only and is not to be taken by way of limitation, the scope of the present invention being limited only by the terms of the appended claims.

## Claims

1. A silicon solar cell comprising:
a p type silicon substrate (1),
an n-type diffusion layer (2) formed at a first main surface side in said p-type substrate (1), and
a p⁺-layer (3a) of high doping concentration formed by ion implantation of group III element having an atomic radius greater than that of Si formed at least partially at a second main surface side in said p-type substrate (1),
wherein:
the doping concentration of said p⁺-layer (3a) is greater than that of said p-type silicon substrate (1), and the doping concentration at the interface (8) between the p-type silicon substrate (1) and the p⁺-layer (3a) is altered abruptly;
**characterized in that**
said p⁺-layer (3a) has a thickness in a range of 1 to several µm and a doping concentration of at least 1 · 10¹⁸/cm³.

2. The silicon solar cell according to claim 1, wherein said p⁺ layer (3a) of high doping concentration is formed all over said second main surface.

3. The silicon solar cell according to claim 1 or 2, wherein said group III element is Al.

4. The silicon solar cell according to anyone of claims 1 to 3, further comprising:
an oxide film (6) formed on said second main surface and including an opening, and
an electrode (5) formed on said oxide film (6) and electrically connected to said p⁺ layer (3a) via said opening.

5. A method of fabricating a silicon solar cell comprising the steps of:
forming an n type diffusion layer (2) at a first main surface side in a p type silicon substrate (1).
forming an oxide film (6) so as to cover a second main surface of said p type substrate (1).
forming a p⁺ layer (3a) of high doping concentration at least partially at said second main surface side within said p type substrate (1) by ion-implanting group III element having an atomic radius greater than that of a Si atom via said oxide film (6), the doping concentration of said p⁺ layer (3a) being greater than that of said p type silicon substrate (1), the doping concentration at the interface (8) between the p type silicon substrate (1) and the p⁺ layer (3a) being altered abruptly, and the p⁺ layer (3a) having a thickness in a range of 1 to several µm and a doping concentration of at least 1 · 10¹⁸/cm³.
forming an opening in said oxide film (6), and
forming an electrode (5) electrically connected to said p⁺ layer (3a) via said opening.

6. The method of fabricating a silicon solar cell according to claim 5, wherein said group III element is Al.

## Patentansprüche

1. Siliziumsolarzelle, umfassend:
ein p-Typ Siliziumsubstrat (1);
eine n-Typ Diffusionsschicht (2), die an einer ersten Hauptoberflächenseite in dem p-Typ Substrat (1) gebildet ist; und
eine p+-Schicht (3a) mit einer hohen Dotierungskonzentration gebildet durch eine Ionenimplantation eines Gruppe III Elements mit einem atomaren Radius größer als derjenige von Si gebildet wenigstens teilweise an einer zweiten Hauptoberflächenseite in dem p-Typ Substrat (1), wobei:
die Dotierungskonzentration der p+-Schicht (3a) größer als diejenige des p-Typ Siliziumsubstrats (1) ist und die Dotierungskonzentration an dem Übergang (8) zwischen dem p-Typ Siliziumsubstrat (1) und der p+-Schicht (3a) abrupt geändert ist;
**dadurch gekennzeichnet, dass**
die p+-Schicht (3a) eine Dicke in einem Bereich von 1 bis mehreren µm und eine Dotierungskonzentration von wenigstens 1 · 1018/cm3 aufweist.

2. Siliziumsolarzelle nach Anspruch 1, wobei die p+-Schicht (3a) mit der hohen Dotierungskonzentration über der gesamten zweiten Hauptoberfläche gebildet ist.

3. Siliziumsolarzelle nach Anspruch 1 oder 2, wobei das Gruppe III Element Al ist.

4. Siliziumsolarzelle nach irgendeinem der Ansprüche 1 bis 3, ferner umfassend:
einen Oxidfilm (6), der auf der zweiten Hauptoberfläche gebildet ist und eine Öffnung umfasst, und
eine Elektrode (5), die auf dem Oxidfilm (6) gebildet und elektrisch mit der p+-Schicht (3a) über die Öffnung verbunden ist.

5. Verfahren zum Herstellen einer Siliziumsolarzelle, umfassend die folgenden Schritte:
Bilden einer n-Typ Diffusionsschicht (2) auf einer ersten Hauptoberflächenseite in einem p-Typ Siliziumsubstrat (1);
Bilden eines Oxidfilms (6), so dass er eine zweite Hauptoberfläche des p-Typ Substrats (1) abdeckt;
Bilden einer p+-Schicht (3a) mit einer hohen Dotierungskonzentration wenigstens teilweise an der zweiten Hauptoberflächenseite innerhalb des p-Typ Substrats (1) durch Ionenimplantation einer Gruppe III Elements mit einem atomaren Radius, der größer als derjenige eines Si-Atoms ist, über dem Oxidfilm (6), wobei die Dotierungskonzentration der p+ - Schicht (3a) größer als diejenige des p-Typ Siliziumsubstrats (1) ist, wobei die Dotierungskonzentration an dem Übergang (8) zwischen dem p-Typ Substrat (1) und der p+-Schicht (3a) abrupt geändert ist und die p+-Schicht (3a) eine Dicke in einem Bereich von 1 bis mehreren µm und eine Dotierungskonzentration von wenigstens 1 · 1018/cm3 aufweist;
Bilden einer Öffnung in dem Oxidfilm (6); und
Bilden einer Elektrode (5), die mit der p+-Schicht (3a) über die Öffnung elektrisch verbunden ist.

6. Verfahren zum Herstellen einer Siliziumsolarzelle nach Anspruch 5, wobei das Gruppe III Element Al ist.

## Revendications

1. Cellule solaire au silicium comprenant :
un substrat en silicium de type p (1) ;
une couche de diffusion de type n (2), formée sur une première surface principale dudit substrat de type p (1) ; et
une couche p⁺ (3a) à forte concentration de dopage formée par l'implantation d'ions d'un élément du groupe III ayant un rayon atomique supérieur à celui du Si, formée au moins partiellement sur une seconde surface principale dudit substrat de type p (1), dans laquelle :
la concentration de dopage de ladite couche p⁺ (3a) est supérieure à celle du substrat (1) en silicium de type p, et la concentration de dopage à l'interface (8) entre le substrat (1) en silicium de type p et la couche p⁺ (3a) est brusquement altérée ;
**caractérisée en ce que**
ladite couche p⁺ (3a) a une épaisseur située dans une plage de 1 à plusieurs µm et une concentration de dopage d'au moins 1•10¹⁸/cm³.

2. Cellule solaire au silicium selon la revendication 1, dans laquelle ladite couche p⁺ (3a) à forte concentration de dopage est formée sur la totalité de ladite seconde surface principale.

3. Cellule solaire au silicium selon la revendication 1 ou 2, dans laquelle ledit élément du groupe III est Al.

4. Cellule solaire au silicium selon l'une quelconque des revendications 1 à 3, comprenant en outre :
une couche d'oxyde (6) formée sur ladite seconde surface principale et comportant une ouverture, et ;
une électrode (5) formée sur ladite couche d'oxyde (6) et connectée électriquement à ladite couche p⁺ (3a) par l'intermédiaire de ladite ouverture.

5. Procédé pour fabriquer une cellule solaire au silicium comportant les étapes de :
formation d'une couche de diffusion de type n (2) sur une première surface principale d'un substrat en silicium de type p (1),
formation d'une couche d'oxyde (6) afin de recouvrir la seconde surface principale dudit substrat en silicium de type p (1),
formation d'une couche p⁺ (3a) à forte concentration de dopage au moins partiellement sur ladite seconde surface principale dudit substrat de type p (1) par implantation d'ions d'un élément du groupe III ayant un rayon atomique supérieur à celui d'un atome de Si, via ladite couche d'oxyde (6), la concentration de dopage de ladite couche p⁺ (3a) étant supérieure à celle dudit substrat en silicium de type p (1), la concentration de dopage à l'interface (8) entre le substrat en silicium de type p (1) et la couche p⁺ (3a) étant brusquement altérée, et la couche p⁺ (3a) ayant une épaisseur dans une plage de 1 à plusieurs µm et une concentration de dopage d'au moins 1•10¹⁸/cm³,
formation d'une ouverture dans ladite couche d'oxyde (6), et
formation d'une électrode (5) électriquement connectée à ladite couche p⁺ (3a) par l'intermédiaire de ladite ouverture.

6. Procédé pour fabriquer une cellule solaire au silicium selon la revendication 5, dans laquelle ledit élément du groupe III est Al.
